# EUROPÄISCHE PATENTSCHRIFT

(11) **EP 3 269 031 B1**
(45) Veröffentlichungstag und Bekanntmachung des Hinweises auf die Patenterteilung: **12.12.2018**
(21) Anmeldenummer: 16707131.5
(22) Anmeldetag: 01.03.2016
(51) Int. Cl.: H02M 3/335, B23K 9/32, H02M 7/155, B23K 9/10

(54) **SCHALTUNGSANORDNUNG MIT TRANSFORMATOR MIT MITTELPUNKTANZAPFUNG UND MESSUNG DER AUSGANGSSPANNUNG**
CONVERTER CONTAINING A TRANSFORMER WITH CENTER TAP AND MEASUREMENT OF THE OUTPUT VOLTAGE
CONVERTISSEUR CONTENANT UN TRANSFORMATEUR AVEC UN POINT MILIEU ET UN DISPOSITIF DE MESURE DE LA TENSION DE SORTIE

(30) Priorität: 09.03.2015 AT 501862015
(43) Veröffentlichungstag der Anmeldung: 17.01.2018
(73) Patentinhaber: Fronius International GmbH, 4643 Pettenbach (AT)
(72) Erfinder: MAGERL, Christian, 3921 Langschlag (AT); MUSIL, Franz Peter, 4652 Steinerkirchen a. d. Traun (AT); EBERL, Robert, 4654 Bad Wimsbach-Neydharting (AT); STEINMAURER, Friedrich, 4562 Steinbach am Ziehberg (AT)
(74) Vertreter: Patentanwälte Pinter & Weiss OG
(86) Internationale Anmeldenummer: PCT/EP2016/054325
(87) Internationale Veröffentlichungsnummer: WO 2016/142217

(56) Entgegenhaltungen:
- CN-Y- 201 219 239
- JP-A- 2011 062 079
- US-A- 3 362 900

## Beschreibung

Die gegenständliche Erfindung betrifft eine Schaltungsanordnung mit mindestens einem Transformator mit Mittelpunktanzapfung, wobei der Mittelpunkt der Sekundärseite des Transformators über eine erste Ausgangsleitung mit einem ersten Ausgangspol verbunden ist und die beiden äußeren Anschlüsse der Sekundärseite des Transformators über jeweils ein elektrisches Schaltelement verbunden sind und mit einer zweiten Ausgangsleitung mit einem zweiten Ausgangspol verbunden sind und mit einer Spannungsmessung zur Messung der zwischen ersten und zweiten Ausgangspol anliegenden Ausgangsspannung der Schaltungsanordnung, wobei zwischen den beiden äußeren Anschlüssen der Sekundärseite des Transformators zumindest zwei in Serie geschaltete Widerstände geschaltet sind, um zwischen den beiden Widerständen einen Messpunkt auszubilden.

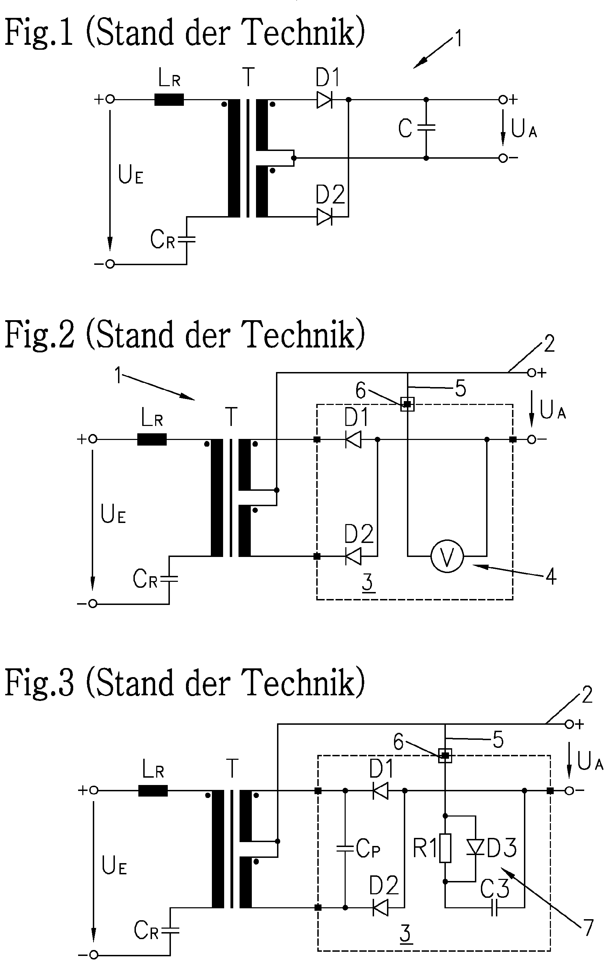

In Stromrichtern, wie z.B. Gleichspannungswandler, Schaltwandlern, resonanten Schaltwandlern, etc., kommen oftmals Transformatoren mit Mittelpunktanzapfung auf der Sekundärseite zum Einsatz. Ein Beispiel dafür ist ein Stromrichter 1 in Form eines bekannten Resonanzwandlers wie in Fig.1 dargestellt, bei dem durch die Drossel L_{R}, die Kapazität C_{R} und die Primärseite des Transformators T ein Schwingkreis gebildet wird. Der Resonanzwandler wird durch ein Pulsmuster am Eingang U_{E} zum Schwingen angeregt. Das Pulsmuster kann z.B. durch eine bekannte Schalteranordnung und einer PWM-Steuerung (in Fig. 1 nicht dargestellt) realisiert werden. Diese Schwingung wird über den Transformator T übertragen und auf der Sekundärseite gleichgerichtet.

Zur Regelung der Ausgangsspannung U_{A} solcher Stromrichter 1 ist in der Regel eine Messung der Ausgangsspannung U_{A} erforderlich. Insbesondere in hohen Leistungsklassen, wie beispielsweise bei Schweißstromquellen anzutreffen, fließen auf der Sekundärseite hohe Ströme. Die Schaltelemente auf der Sekundärseite des Stromrichters 1 sind üblicherweise auf einem Schaltungsträger 3, wie z.B. einer Schaltungsplatine (wie in Fig.2), oder ähnlichem, angeordnet. Die Schaltungselemente können aber auch über Kupferbügel (insbesondere bei sehr hohen Strömen oder Spannungen) verbunden sein. Um die stromführende Plus-Ausgangsleitung 2 des Stromrichters 1 nicht über den Schaltungsträger 3 führen zu müssen, was einen großen Kupferquerschnitt auf dem Schaltungsträger 3 notwendig machen würde, wird die Plus-Ausgangsleitung 2 in der Regel als separate Leitung nach außen geführt und nicht über einen Schaltungsträger 3, auf dem die Spannungsmessung 4 zur Messung der Ausgangsspannung U_{A} implementiert ist, wie in Fig.2 dargestellt. Das macht es aber notwendig, die Plus-Ausgangsleitung 2 über eine zusätzliche Verbindungsleitung 5 mit dem Schaltungsträger 3 zu verbinden. Dazu wird an der Schaltungsplatine 3 eine Buchse 6 angeordnet, an der die Verbindungsleitung 5 angeschlossen wird. Die zusätzliche Verbindungsleitung 5 sowie die Notwendigkeit einer Buchse 6 am Schaltungsträger 3 erhöhen aber natürlich ebenfalls den Aufwand der elektrischen Baugruppe. Dasselbe gilt analog auch bei der Verwendung von Kupferbügeln, da auch dabei nach dem Stand der Technik zur Spannungsmessung zwischen den beiden Ausgangspolen eine Verbindungsleitung 5 zur Verbindung der Plus-Ausgangsleitung 2 mit der Spannungsmesseinheit erforderlich ist.

Abgesehen davon kann es vorkommen, dass sich die Verbindungsleitung 5 mit der Zeit löst, oder dass bei der Montage gänzlich vergessen wird, die Verbindungsleitung 5 mit dem Schaltungsträger 3 oder mit der Plus-Ausgangsleitung 2 zu verbinden. Beides führt in der Regel zum Ausfall des geregelten Stromrichters 1, der einen Messwert der Ausgangsspannung U_{A} für den Betrieb benötigt. Insbesondere kann es bei Wegfall der Verbindungsleitung 5 zu einer Überspannung an den Dioden D1, D2 kommen, die diese auch zerstören kann. Es ist daher wünschenswert, auf diese zusätzliche Verbindungsleitung 5, die eine Fehlerquelle darstellt, zu verzichten.

Die US 4,164,016 A zeigt einen Transformator mit Mittelpunktanzapfung, bei dem zwischen den äußeren Anschlüssen der Sekundärseite mittels zwei Widerständen ein Messpunkt geschaffen wird. Es wird eine Spannung zwischen dem Messpunkt und dem Mittelpunkt gemessen, wodurch weiterhin eine Verbindungsleitung zum Mittelpunkt benötigt wird.

Die US 3 362 900 A offenbart eine Vorrichtung, in der über einen Trafo mit Mittelpunktanzapfung mittels eines Regelkreises ein Strom in die Hülle eines Schiffes eingeprägt wird. Der Mittelpunkt der Sekundärseite ist mit einer Kathode verbunden, welche in Meerwasser gelegt wird. Eine Spannungsmesseinheit ermittelt die Spannung zwischen der Hülle und einer Referenzanode und regelt darauf basierend einen Strom. Die JP 2011 062079 A offenbart eine Verstärkerschaltung mit einem vereinfachten Schaltungsaufbau, die CN 201 219 239 Y eine Verstärkerschaltung, welche eine erhöhte Ausgangsleistung ermöglicht. Obwohl die Probleme des Standes der Technik anhand des konkreten Beispiels eines Stromrichters in Form eines Resonanzwandlers mit Transformator mit Mittelpunktanzapfung beschrieben sind, gilt das allgemein für jede Schaltungsanordnung mit einem Transformator mit Mittelpunktanzapfung, bei der die Ausgangsspannung an der Sekundärseite gemessen wird. Ein Transformator mit Mittelpunktanzapfung wird beispielsweise auch in Mittelpunktgleichrichtern oder Synchrongleichrichtern verwendet.

Es ist daher eine Aufgabe der gegenständlichen Erfindung, eine Schaltungsanordnung mit einem Transformator mit Mittelpunktanzapfung anzugeben, die eine einfache und sichere Spannungsmessung der Ausgangsspannung an der Sekundärseite ermöglicht, ohne den schaltungstechnischen Aufwand zu erhöhen.

Diese Aufgabe wird erfindungsgemäß dadurch gelöst, dass eine Spannungsmesseinheit vorgesehen ist, die die mit der Ausgangsspannung korrespondierende Spannung zwischen Messpunkt und zweitem Ausgangspol misst. Durch die beiden in Serie geschalteten Widerstände wird ein Messpunkt geschaffen, an dem gegenüber dem zweiten Ausgangspol eine zur Ausgangsspannung korrespondierende Spannung anliegt. Damit müssen lediglich die beiden Widerstände angeordnet werden, um eine zur Ausgangsspannung korrespondieren-de Spannung, und damit auch die Ausgangsspannung, auf einfache Weise messen zu können. Eine Verbindungsleitung zwischen dem ersten Ausgangspol und dem Schaltungsträger bzw. zwischen ersten Ausgangspol und Spannungsmesseinheit ist damit nicht mehr erforderlich.

In einer vorteilhaften Ausgestaltung sind die elektrischen Schaltelemente und die beiden Widerstände auf zumindest einem Schaltungsträger, insbesondere einer Schaltungsplatine, angeordnet. Am Schaltungsträger müssen dann keine Vorkehrungen getroffen werden, z.B. in Form einer Verbindungsbuchse, um die erste Ausgangsleitung mit dem Schaltungsträger zu verbinden, was dem schaltungstechnischen Aufwand reduziert.

Wenn zwischen Messpunkt und dem zweiten Ausgangspol zumindest ein weiterer Widerstand geschaltet ist, kann aufgrund des entstehenden Spannungsteilers der eingangsseitige Spannungsbereich der Spannungsmesseinheit verringert werden. Die Spannungsmesseinheit kann damit vorteilhafterweise auf eine geringere Messspannung ausgelegt werden.

Die erfindungsgemäße Schaltungsanordnung kommt besonders vorteilhaft bei einem Resonanzwandler mit einem Resonanzkreis, insbesondere als Schweißstromquelle, zur Anwendung, da dort die Messung der Ausgangsspannung zur Regelung der Ausgangsspannung wichtig ist.

Gewisse Resonanzwandler, wie z. B. Serien-Parallel-Resonanzwandler, haben aber die Eigenschaft, dass sich die Ausgangsspannung U_{A} im Leerlauf (also ohne angeschlossene Last) aufgrund des mit C_{P} gebildeten Schwingkreises derart erhöht, dass eine Regelung des Resonanzwandlers mit einer ausgangsseitigen Zusatzbeschaltung 7 (Fig.3) vorteilhaft ist. Das ist insbesondere in Schweißstromquellen der Fall, wo auch im Leerlauf die Erhaltung einer gewissen Ausgangsspannung U_{A} erwünscht ist. Dazu wird der Resonanzwandler im Leerlauf gepulst betrieben. An den Eingang U_{E} des Resonanzwandlers werden hierzu für eine bestimmte Zeitspanne Spannungspulse angelegt. Die durch den Resonanzwandler erzeugte Schwingung, lädt den Kondensator C3 auf der Sekundärseite über die Diode D3 auf. In der Zeit, in der keine Spannungspulse angelegt werden, entlädt sich der Kondensator C3 über den Widerstand R1. Es stellt sich am Ausgang des Resonanzwandlers daher eine mittlere Ausgangsspannung U_{A} ein, die über Einstellung der Spannungspulse am Eingang auf einen gewünschten Pegel gehalten werden kann. Im Normalbetrieb des Resonanzwandlers hat diese Zusatzbeschaltung 7 keinen Einfluss. Trotzdem muss der Kondensator C3 auf die maximale Ausgangsspannung U_{A} und eine maximale Pulsfrequenz ausgelegt sein und ist daher entsprechend groß zu dimensionieren, was entsprechenden Platz auf dem Schaltungsträger 3 erfordert. Diese Schaltung bedingt aber natürlich ebenfalls die Verbindungsleitung 5, um die Plus-Ausgangsleitung 2 mit dem Schaltungsträger 3, auf der diese Zusatzbeschaltung 7 angeordnet ist, zu verbinden. Fällt die Verbindungsleitung 5 weg, muss aber trotzdem sichergestellt werden, dass die Ausgangsspannung U_{A} im Leerlauf des Resonanzwandlers auf einen gewünschten Spannungspegel geregelt werden kann.

Es ist daher eine weitere Aufgabe der gegenständlichen Erfindung sicherzustellen, dass die Ausgangsspannung im Leerlauf eines Resonanzwandlers mit der erfindungsgemäßen Schaltungsanordnung unter Vermeidung der oben genannten schaltungstechnischen Probleme mit einer einfachen Zusatzbeschaltung auf einen gewünschten Wert geregelt bzw. eingestellt werden kann.

Diese weitere Aufgabe wird für einen Resonanzwandler erfindungsgemäß dadurch gelöst, dass parallel zu den elektrischen Schaltelementen auf der Sekundärseite jeweils ein Kondensator geschaltet ist. Die Kondensatoren müssen dabei im Normalbetrieb (also mit angeschlossener Last) nur mehr jeweils eine halbe Periode Strom führen und können daher wesentlich kleiner dimensioniert werden, als in der Schaltung nach dem Stand der Technik. Damit kann auch ein eventueller Schaltungsträger kleiner ausgeführt werden und es kann auch auf die bisher notwendige Verbindungsleitung zwischen erstem Ausgangspol und dem Schaltungsträger verzichtet werden.

Die gegenständliche Erfindung wird nachfolgend unter Bezugnahme auf die Figuren 1 bis 7 näher erläutert, die beispielhaft, schematisch und nicht einschränkend vorteilhafte Ausgestaltungen der Erfindung zeigen. Dabei zeigt
Fig.1 einen typischen Resonanzwandler nach dem Stand der Technik,
Fig.2 die im Stand der Technik übliche Spannungsmessung an der Sekundärseite eines Transformators mit Mittelpunktanzapfung,
Fig.3 die im Stand der Technik übliche Zusatzbeschaltung zur Regelung der Ausgangsspannung eines Serien-Parallel-Resonanzwandler im Leerlauf,
Fig.4 eine Schaltungsanordnung mit einem Transformator mit Mittelpunktanzapfung und erfindungsgemäßer Spannungsmessung der Ausgangsspannung,
Fig.5 einen Serien-Parallel-Resonanzwandler mit erfindungsgemäßer Sekundärbeschaltung zur Einstellung der Leerlaufspannung,
Fig.6 die sich im Serien-Parallel-Resonanzwandler ergebenden Spannungsverläufe im Leerlauffall und
Fig.7 einen Serien-Parallel-Resonanzwandler mit erfindungsgemäßer Messanordnung zur Spannungsmessung und Sekundärbeschaltung zur Regelung der Ausgangsspannung im Leerlauf.

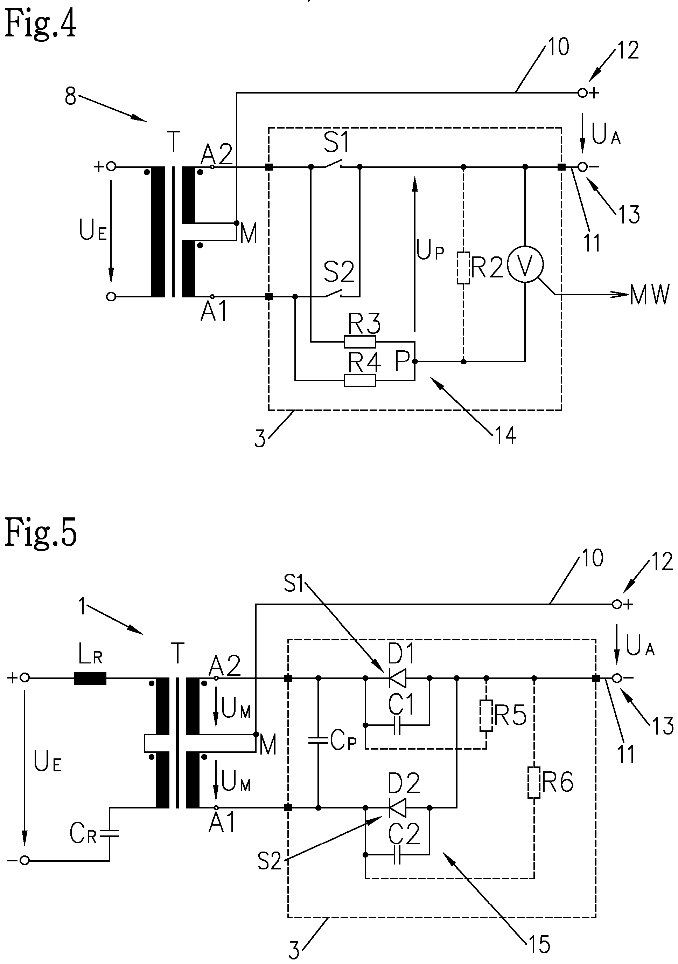

Fig.4 zeigt eine Schaltungsanordnung 8 mit einem Transformator T mit sekundärseitiger Mittelpunktanzapfung. Auf der Sekundärseite des Transformators T mit Mittelpunktanzapfung sind zumindest drei Anschlüsse vorhanden. Ein Anschluss für den Mittelpunkt M und zwei Anschlüsse an den Enden der sekundärseitigen Wicklung, wobei diese Anschlüsse als Äußere Anschlüsse A1, A2 bezeichnet werden.

Im Allgemeinen wird aber festgehalten, dass unter einem Transformator mit Mittelpunktanzapfung im Sinne der Erfindung auch die Verwendung von zwei oder mehr Transformatorwicklungen mit gemeinsamen Kern, bei denen die sekundärseitigen und die primärseitigen Wicklungen jeweils in Reihe geschaltet sind, verstanden wird (wie in Fig.5 dargestellt). Auch unabhängige Transformatoren mit parallele geschalteten Primärwicklungen und in Reihe geschalten Sekundärwicklungen sind dabei eingeschlossen. Eine elektrische Verbindung zwischen zwei in Reihe geschalteten sekundärseitigen Wicklungen entspricht dann dem Mittelpunkt M, an dem die erste Ausgangsleitung 10 angeschlossen werden kann.

Der sekundärseitige Mittelpunkt M ist über eine erste Ausgangsleitung 10, hier eine Plus-Ausgangsleitung, als erster Ausgangspol 12, hier der Pluspol, nach außen geführt. Die erste Ausgangsleitung 10 wird hierbei allerdings nicht über einen Schaltungsträger 3, wie beispielsweise eine Schaltungsplatine, geführt, sondern direkt als Leitung nach außen geführt. Die beiden äußeren, bzw. nicht seriell verschalteten, sekundärseitigen Anschlüsse A1, A2 der Sekundärseite des Transformators T sind jeweils in bekannter Weise auf einen ersten Anschluss eines Schaltelements S1, S2 geführt. Die jeweils zweiten Anschlüsse der Schaltelemente S1, S2 sind miteinander verbunden und bilden den zweiten Ausgangspol 13, hier den Minuspol, des Gleichrichters, der mit einer zweiten Ausgangsleitung 11, hier einer Minus-Ausgangsleitung, nach außen geführt ist.

Falls als elektrische Schaltelemente S1, S2 passive Schaltelemente in Form von Dioden verwendet werden, erhält man einen bekannten Mittelpunktgleichrichter. Werden als elektrische Schaltelemente S1, S2 aktive Schaltelemente, beispielsweise Halbleiterschalter, z.B. MOSFETs, verwendet, erhält man einen bekannten Synchrongleichrichter. Da die Funktionen eines Mittelpunktgleichrichters und eines Synchrongleichrichters hinlänglich bekannt sind, und für die gegenständliche Erfindung unerheblich sind, wird hier nicht näher darauf eingegangen.

Die Schaltelemente S1, S2, sind in herkömmlicher Weise auf einem Schaltungsträger 3 angeordnet. Selbstverständlich kann der Schaltungsträger 3 auch geteilt ausgeführt sein. Insbesondere im Falle von aktiven Schaltelementen S1, S2 wird der Leistungsteil mit den aktiven Schaltelementen S1, S2 oft auf einem separaten Schaltungsträger 3 angeordnet. Zusätzlich ist auf dem Schaltungsträger 3 zur Spannungsmessung eine erfindungsgemäße elektrische Messanordnung 14 zur Messung der Ausgangsspannung U_{A} angeordnet. Die Schaltungselemente der Sekundärseite können aber auch durch Kupferbügel miteinander verbunden sein. Auch eine sekundärseitige Schaltungsanordnung als Kombination mit Schaltungsträger 3 und Kupferbügel ist denkbar. Beispielsweise könnte die Messanordnung 14 zur Messung der Ausgangsspannung U_{A} auf einem Schaltungsträger 3 angeordnet sein und die restlichen Schaltungselemente mittels Kupferbügel verbunden sein.

Diese Messanordnung 14 zur Messung der Ausgangsspannung U_{A} besteht im Wesentlichen aus zwei Widerständen R3, R4, die in Serie zwischen die beiden äußeren Anschlüsse A1, A2 der Sekundärseite des Transformators T geschaltet sind. Dadurch wird zwischen den beiden Widerständen R3, R4 ein Messpunkt P erzeugt, an dem sich gegenüber dem zweiten Ausgangspol 13 eine Spannung U_{P} einstellt, die mit der am Mittelpunkt M anliegenden Ausgangsspannung U_{A} korrespondiert. Diese Spannung U_{P} am Messpunkt P kann mit einer beliebigen Spannungsmesseinheit V gemessen und als analoger oder digitaler Messwert MW zur Verfügung gestellt werden. Beispielsweise kann die Spannungsmesseinheit V als Verstärkerschaltung mit einem Operationsverstärker ausgeführt sein, wobei der Ausgang der Verstärkerschaltung in einem Analog-Digital-Wandler digitalisiert wird und als digitaler Messwert MW nach außen geführt ist.

Sind die beiden Widerstände R3, R4 gleich, dann entspricht die Spannung U_{P} am Messpunkt P der Ausgangsspannung U_{A} am Mittelpunkt M, also im gezeigten Ausführungsbeispiel der Spannung am ersten Ausgangspol 12. Sind die Widerstände R3, R4 nicht gleich, dann stellt sich am Messpunkt P eine dem Verhältnis der Widerstände R3, R4 entsprechende Spannung ein. In beiden Fällen kann damit am Messpunkt P die Ausgangsspannung U_{A} gemessen werden, indem die Spannung U_{P} des Messpunkt P gegenüber dem zweiten Ausgangspol 13 gemessen wird, wie in Fig.4 angedeutet.

Die Spannung U_{P} am Messpunkt P kann direkt gemessen werden, aber auch die Messung über einen Spannungsteiler ist denkbar. Dies erlaubt die Verwendung einer Spannungsmesseinheit V mit einem reduzierten Eingangsbereich, wodurch schaltungstechnische Vereinfachungen erreichbar sind. Dazu kann zwischen Messpunkt P und zweitem Ausgangspol 13 durch einen zusätzlichen Widerstand R2 ein Spanungsteiler erzeugt werden, wie in Fig.4 angedeutet. Dabei bewirkt der Widerstand R2 im Zusammenhang mit den Widerständen R3 und R4 am Messpunkt P eine entsprechende Verringerung der Spannung U_{P}, die aber dennoch zur Ausgangsspannung U_{A} proportional ist. Sollte die Spannungsmesseinheit V eine noch geringere Eingangsspannung erfordern, kann in bekannter Weise der Widerstand R2 in einem passenden Verhältnis auf zwei Widerstände aufgeteilt werden, um eine Anpassung auf den Eingangsspannungsbereich der Spannungsmesseinheit V zu erreichen.

Mit dieser erfindungsgemäßen Messanordnung 14 für die Spannungsmessung der Ausgangsspannung U_{A} ist es folglich nicht mehr notwendig, die erste Ausgangsleitung 10 über den Schaltungsträger 3 zu führen oder die erste Ausgangsleitung 10, wie im Stand der Technik, mit dem Schaltungsträger 3, oder mit der Spannungsmesseinheit V , über eine zusätzliche Verbindungsleitung 5 zu verbinden.

Fig.5 zeigt einen Stromrichter 1 in Form eines Serien-Parallel-Resonanzwandlers mit einem primärseitigen Serienschwingkreis aus Drossel L_{R}, Schwingkondensator C_{R} und der Primärseite des Transformators T, einem sekundärseitigen Parallelschwingkreis aus Schwingkondensator C_{P} und der Sekundärseite des Transformators T und einem Mittelpunktgleichrichter (also mit Dioden D1, D2 als elektrische Schaltelemente S1, S2) auf der Sekundärseite. Die Primärseite ist hierbei nicht vollständig dargestellt, insbesondere fehlt die an sich bekannte elektrische Schaltung zur Erzeugung der dargestellten Eingangsspannung U_{E}. Selbstverständlich könnte der primärseitige Schwingkreis bekanntermaßen aber auch als Parallelschwingkreis ausgeführt sein, bei dem der Schwingkondensator C_{R} beispielsweise parallel zur Primärseite des Transformators T geschaltet ist. Ebenso könnte der Schwingkreis bekannter Weise auch auf der Sekundärseite anders oder gar nicht ausgebildet sein. Gleichfalls könnten natürlich auch die Dioden D1, D2 umgekehrt gepolt sein oder durch andere elektrische Schaltelemente S1, S2 ersetzt sein.

Um im Leerlauf die Ausgangsspannung U_{A} auf einen gewünschten Wert zu halten, wird parallel zu den elektrischen Schaltelementen S1, S2, hier Dioden D1, D2, jeweils zumindest ein Kondensator C1, C2 geschaltet. Damit ergibt sich zusätzlich der Effekt, mit allen damit verbundenen und oben erläuterten Vorteilen, dass auch für die Sekundärbeschaltung 15 zur Einstellung der Leerlaufspannung keine separate Verbindung zwischen erster Ausgangsleitung 10 und Schaltungsträger 3 notwendig ist.

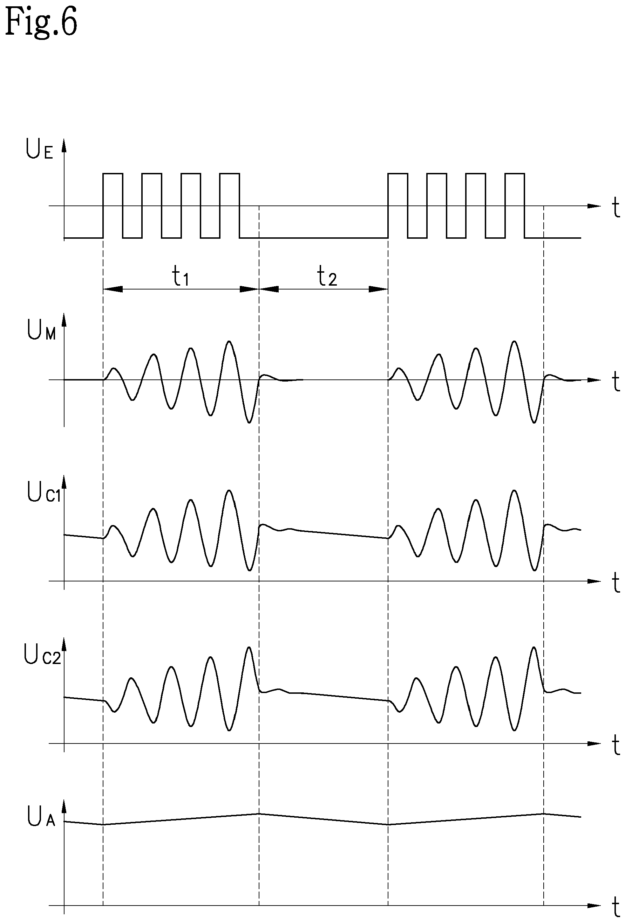

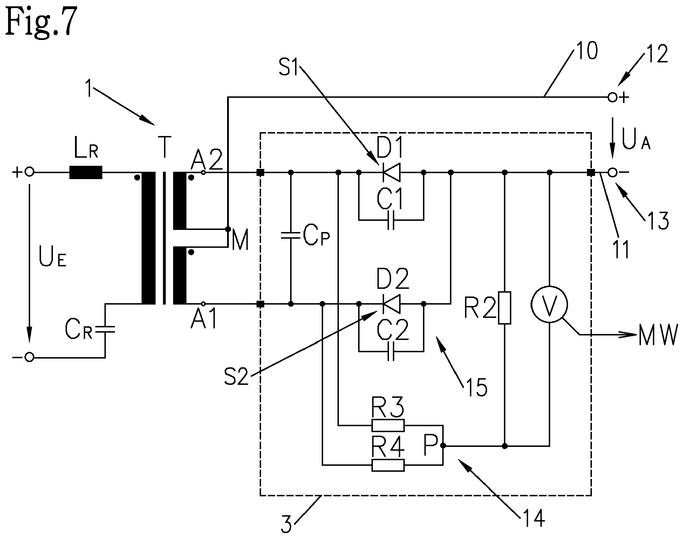

Im Leerlauf soll am Resonanzwandler 1 eine gewünschte Ausgangsspannung U_{A} aufrechterhalten werden. Dazu werden an der Primärseite des Transformtors T für eine bestimmte Zeitspanne t₁ Spannungsimpulse U_{E} angelegt, die den Resonanzkreis auf der Primärseite anregen. Die Anregung führt zu einer Schwingung an der Sekundärseite des Transformators T. Im Leerlauf schwingen auch die an den Kondensatoren C1, C2 anliegenden Spannungen um das Niveau der Ausgangsspannung U_{A}. Die Kondensatoren C1, C2 werden dadurch während der Anregung auf der Primärseite in der Zeitspanne t₁ geladen, was auch zu einer Erhöhung der Leerlaufspannung am Ausgang U_{A} führt. Danach wird die primärseitige Anregung für eine zweite Zeitspanne t₂ unterbrochen. In dieser Phase entladen sich die Kondensatoren C1, C2. Dazu können auch Entladewiderstände R5, R6, vorgesehen sein, wie in Fig.5 angedeutet. Ohne Entladewiderstände R5, R6 entladen sich die Kondensatoren C1, C2 gemäß ihren Selbstentladeeigenschaften. Falls die Sekundärbeschaltung 15 gemeinsam mit der Messanordnung 14 zur Messung der Ausgangsspannung U_{A} implementiert ist (wie in Fig.7), dann dienen die Widerstände R2, R3, R4 der Messanordnung 14 gleichzeitig als Entladewiderstände. Während der Entladung der Kondensatoren C1, C2 sinkt die Leerlaufspannung U_{A} am Ausgang. Es ergibt sich somit am Ausgang im Leerlauf eine mittlere Ausgangsspannung U_{A}. Die Ausgangsspannung U_{A} kann damit durch Einstellen der Spannungsimpulse U_{E}, der Pulsfrequenz und der Zeitspannen t₁, t₂ auf einen gewünschten Wert gehalten werden. Im Normalbetrieb (mit einer angeschlossenen elektrischen Last am Ausgang) hat diese Sekundärbeschaltung 15 keinen Einfluss. Die sich beispielsweise bei einem Serien-Parallel-Resonanzwandler ergebenden Spannungsverläufe im Leerlauf sind in Fig. 6 schematisch dargestellt.

Die beiden Kondensatoren C1, C2 der Sekundärbeschaltung 15 können dabei kleiner dimensioniert werden, als der Kondensator C3 in der bisher üblichen Schaltung nach dem Stand der Technik (Fig.3). Damit kann auch Platz auf dem Schaltungsträger 3 eingespart werden. Abgesehen davon kann damit auch die thermische Belastung des Schaltungsträgers 3 reduziert werden, was ebenfalls dazu führt, dass der Schaltungsträger 3 verkleinert werden kann.

Die kleineren Kapazitätswerte C1, C2 bewirken aber auch, dass die Ausgangsspannung U_{A} im Leerlauf schneller absinkt, was insbesondere für die Anwendung in Schweißstromquellen von Vorteil ist, weil damit die erlaubte Maximalspannung nach Schweißende schneller erreicht wird.

Die Messanordnung 14 zur Spannungsmessung und die Sekundärbeschaltung 15 zur Regelung der Ausgangsspannung U_{A} im Leerlauf lassen sich natürlich auch kombinieren, wie in Fig.7 anhand eines Resonanzwandlers 1 mit Mittelpunktgleichrichter dargestellt. Eine solche Kombination ist ganz besonders vorteilhaft, da dann auch die Ausgangsspannung U_{A} im Leerlauf (Leerlaufspannung) durch Messen der zur Ausgangsspannung U_{A} korrespondierenden Spannung U_{P} am Messpunkt P auf einen gewünschten Wert geregelt werden kann, bzw. ein gewünschter Wert der Leerlaufspannung sichergestellt werden kann.

## Patentansprüche

1. Schaltungsanordnung mit mindestens einem Transformator (T) mit Mittelpunktanzapfung, wobei der Mittelpunkt (M) der Sekundärseite des Transformators über eine erste Ausgangsleitung (10) mit einem ersten Ausgangspol (12) verbunden ist und die beiden äußeren Anschlüsse (A1, A2) der Sekundärseite des Transformators (T) über jeweils ein elektrisches Schaltelement (S1, S2) verbunden sind und mit einer zweiten Ausgangsleitung (11) mit einem zweiten Ausgangspol (13) verbunden sind, und mit einer Messanordnung (14) zur Messung der zwischen ersten Ausgangspol (12) und zweiten Ausgangspol (13) anliegenden Ausgangsspannung (U_{A}) der Schaltungsanordnung (8), wobei zwischen den beiden äußeren Anschlüssen (A1, A2) der Sekundärseite des Transformators (T) zumindest zwei in Serie geschaltete Widerstände (R3, R4) geschaltet sind, um zwischen den beiden Widerständen (R3, R4) einen Messpunkt (P) auszubilden, **dadurch gekennzeichnet, dass** eine Spannungsmesseinheit (V) vorgesehen ist, die eine mit der Ausgangsspannung (U_{A}) korrespondierende Spannung (U_{P}) zwischen Messpunkt (P) und zweitem Ausgangspol (13) misst.

2. Schaltungsanordnung nach Anspruch 1, **dadurch gekennzeichnet, dass** die elektrischen Schaltelemente (S1, S2) und die beiden Widerstände (R3, R4) auf zumindest einem Schaltungsträger (3), insbesondere einer Schaltungsplatine, angeordnet sind.

3. Schaltungsanordnung nach Anspruch 1, **dadurch gekennzeichnet, dass** die elektrischen Schaltelemente (S1, S2) und die beiden Widerstände (R3, R4) auf einem gemeinsamen Schaltungsträger (3), insbesondere einer gemeinsamen Schaltungsplatine, angeordnet sind.

4. Schaltungsanordnung nach Anspruch 1, **dadurch gekennzeichnet, dass** zwischen Messpunkt (P) und dem zweiten Ausgangspol (13) zumindest ein weiterer Widerstand (R2) geschaltet ist.

5. Resonanzwandler mit einem Resonanzkreis und einer Schaltungsanordnung (8) nach einem der Ansprüche 1 bis 4.

6. Resonanzwandler nach Anspruch 5, **dadurch gekennzeichnet, dass** parallel zu den elektrischen Schaltelementen (S1, S2) jeweils zumindest ein Kondensator (C1, C2) geschaltet ist.

7. Verfahren zum Bestimmen einer Ausgangsspannung (U_{A}) zwischen einem ersten Ausgangspol (12), der mit einem Mittelpunkt (M) verbunden ist, und einem zweiten Ausgangspol (13), der über jeweils ein elektrisches Schaltelement (S1, S2) mit den beiden äußeren Anschlüssen (A1, A2) der Sekundärseite des Transformators (T) verbunden ist, wobei zwischen den beiden Anschlüssen (A1,A2) ein Messpunkt (P) zwischen zumindest zwei in Serie geschalteten Widerständen (R3, R4) ausgebildet wird, **dadurch gekennzeichnet, dass** eine mit der Ausgangsspannung (U_{A}) korrespondierende Spannung (U_{P}) zwischen Messpunkt (P) und zweitem Ausgangspol (13) gemessen wird.

## Claims

1. A circuit arrangement with at least one transformer (T) with center tap, wherein the center point (M) of the secondary side of the transformer is connected via a first output line (10) to a first output pole (12) and the two outer connections (A1, A2) of the secondary side of the transformer (T) are connected via one electrical circuit element (S1, S2) each, and connected via a second output line (11) to a second output pole (13), and to a measurement apparatus (14) for measuring the output voltage (U_{A}) of the circuit arrangement (8) applied between the first output pole (12) and the second output pole (13), wherein at least two series-connected resistors (R3, R4) are connected between the two outer connections (A1, A2) of the secondary side of the transformer (T) for forming a measurement point (P) between the two resistors (R3, R4), **characterized in that** a voltage measurement unit (V) is provided that measures a voltage (Up) between the measurement point (P) and the second output pole (13) that corresponds to the output voltage (U_{A}).

2. The circuit arrangement according to claim 1, **characterized in that** the electrical circuit elements (S1, S2) and the two resistors (R3, R4) are disposed on at least one substrate (3), particularly a circuit board.

3. The circuit arrangement according to claim 1, **characterized in that** the electrical circuit elements (S1, S2) and the two resistors (R3, R4) are disposed on a joint substrate (3), particularly a joint circuit board.

4. The circuit arrangement according to claim 1, **characterized in that** at least one further resistor (R2) is connected between the measurement point (P) and the second output pole (13).

5. A resonant converter with a resonant circuit and a circuit arrangement (8) according to any one of claims 1 to 4.

6. The resonant converter according to claim 5, **characterized in that** at least one capacitor (C1, C2) each is connected parallel relative to the electrical circuit elements (S1, S2).

7. A method for determining an output voltage (U_{A}) between a first output pole (12) that is connected to a center point (M) and a second output pole (13) that is connected via an electrical circuit element (S1, S2) to the two outer connections (A1, A2) of the secondary side of the transformer (T), wherein, between the two connections (A1, A2), a measurement point (P) is formed between at least two series-connected resistors (R3, R4) **characterized in that** a voltage (Up) is measured between the measurement point (P) and the second output pole (13) that corresponds to the output voltage (U_{A}).

## Revendications

1. Circuiterie muni d'au moins un transformateur (T) à prise de point médian, dans lequel le point médian (M) du côté secondaire du transformateur est relié à un premier pôle de sortie (12) par une première conduite de sortie (10) et les deux raccordement extérieurs (A1, A2) du côté secondaire du transformateur (T) sont reliés chacun par un élément de commutation électrique (S1, S2) et sont reliés à un second pôle de sortie (13) par une seconde conduite de sortie (11), et muni d'un dispositif de mesure (14) pour la mesure de la tension de sortie (U_{A}) de la circuiterie (8) existant entre le premier pôle de sortie (12) et le second pôle de sortie (13), au moins deux résistances commutées en série (R3, R4) étant commutées entre les deux raccordements extérieurs (A1, A2) du côté secondaire du transformateur (T), pour former un point de mesure (P) entre les deux résistances (R3, R4), **caractérisée en ce qu'**une unité de mesure de tension (V) est prévue, laquelle mesure une tension (U_{P}) correspondant à la tension de sortie (U_{A}) entre le point de mesure (P) et le second pôle de sortie (13).

2. Circuiterie selon la revendication 1, **caractérisée en ce que** les éléments de commutation électriques (S1, S2) et les deux résistances (R3, R4) sont disposés sur au moins un support de circuit (3), en particulier une carte de circuit.

3. Circuiterie selon la revendication 1, **caractérisée en ce que** les éléments de commutation électriques (S1, S2) et les deux résistances (R3, R4) sont disposés sur un support de circuit (3) commun, en particulier une carte de circuit commune.

4. Circuiterie selon la revendication 1, **caractérisée en ce qu'**au moins une autre résistance (R2) est commutée entre le point de mesure (P) et le second pôle de sortie (13).

5. Convertisseur résonant muni d'un circuit résonant et d'une circuiterie (8) selon l'une des revendications 1 à 4.

6. Convertisseur selon la revendication 5, **caractérisé en ce qu'**au moins un condensateur (C1, C2) est commuté parallèlement à chacun des éléments de commutation électriques (S1, S2).

7. Procédé de détermination d'une tension de sortie (U_{A}) entre un premier pôle de sortie (12), qui est relié à un point médian (M), et un second pôle de sortie (13), qui est relié aux deux raccordements extérieurs (A1, A2) du côté secondaire du transformateur (T) par un élément de commutation électrique (S1, S2) pour chacun des deux raccordements extérieurs, un point de mesure (P) étant formé entre au moins deux résistances commutées en série (R3, R4) entre les deux raccordements (A1, A2), **caractérisé en ce qu'**une tension (U_{P}) correspondant à la tension de sortie (U_{A}) est mesurée entre le point de mesure (P) et le second pôle de sortie (13).
